(19) Europäisches Patentamt
European Patent Office
Office européen des brevets

(11) **EP 4 549 977 A1**

(12) **EUROPEAN PATENT APPLICATION**
published in accordance with Art. 153(4) EPC

(43) Date of publication:
**07.05.2025  Bulletin 2025/19**

(21) Application number: **23845243.7**

(22) Date of filing: **30.06.2023**

(51) International Patent Classification (IPC):
***G01R 31/52*** (2020.01)

(52) Cooperative Patent Classification (CPC):
**G01R 31/52**

(86) International application number:
**PCT/CN2023/104817**

(87) International publication number:
**WO 2024/022030 (01.02.2024 Gazette 2024/05)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority:  **28.07.2022  CN 202210898895**

(71) Applicant: **BYD Company Limited
Shenzhen, Guangdong 518118 (CN)**

(72) Inventors:
• **CHEN, Mingwen
Shenzhen, Guangdong 518118 (CN)**
• **XUE, Penghui
Shenzhen, Guangdong 518118 (CN)**
• **LI, Xiangxiang
Shenzhen, Guangdong 518118 (CN)**
• **SHI, Lei
Shenzhen, Guangdong 518118 (CN)**
• **LI, Weicheng
Shenzhen, Guangdong 518118 (CN)**

(74) Representative: **Taor, Simon Edward William et al
Venner Shipley LLP
200 Aldersgate
London EC1A 4HD (GB)**

(54) **ELECTRIC LEAKAGE DETECTION DEVICE AND METHOD, AND VEHICLE**

(57)    An electric leakage detection device, applying an electric leakage detection method and applied to a vehicle, and comprising a detection unit, a sampling unit and a signal processing unit. The detection unit is separately connected to two phase discharge paths of a power supply and is used for separately establishing a detection loop for the two phase discharge paths when the power supply discharges. The sampling unit is electrically connected to the detection unit and is used for collecting a first detection voltage of a first phase discharge path and/or a second detection voltage of a second phase discharge path from the detection loop. The signal processing unit is connected to the sampling unit, and is used for asynchronously receiving the first detection voltage and the second detection voltage from the sampling unit, and determining electric leakage characteristics of the power supply according to the first detection voltage and the second detection voltage.

FIG. 5

**Description**

## CROSS-REFERENCE TO RELATED APPLICATIONS

The present disclosure claims priority to Chinese Patent Application No. 202210898895.X, entitled "ELECTRIC LEAKAGE DETECTION DEVICE AND METHOD, AND VEHICLE" and filed on July 28, 2022. The entire content of the above-referenced application is incorporated herein by reference.

## FIELD

The present disclosure relates to the field of driving devices, and specifically, to a electric device for detecting electric leakage, a method and a vehicle.

## BACKGROUND

As the new energy electric vehicle progresses, the demand for the new energy electric vehicles are increased, and there is a growing need for vehicles to have discharge functions, when a vehicle power supply supplies power to an external electric device, the electric-leakage detection and protection of the power supply is currently a major challenge.
At present, in the electric-leakage detection of the electric vehicle, the positive and negative direct current power supplies are respectively applied between the high-voltage loop and the vehicle body, to configure a loop with the insulation resistance of the whole vehicle, and the change in the insulation resistance value of the whole vehicle is obtained by the method. Since the device for detecting electric leakage is provided between the high-voltage loop and the vehicle body, it is necessary to increase the current flowing through the high-voltage loop during the operation of the device for detecting electric leakage, and the insulation performance of the whole vehicle is affected.

## SUMMARY

In view of the above technical problems, embodiments of the present disclosure propose an electric device for detecting electric leakage, a detection method, and a vehicle that executes a fault detection by the electric device for detecting electric leakage, which can improve the reliability of electric-leakage detection of a power supply discharge loop and improve the insulation characteristics of an alternating current output end of the power supply.
An embodiment of the present disclosure discloses a device for detecting electric leakage includes a detection unit, a sampling unit, and a signal processing unit, the detection unit is separately connected to a first phase discharge path and a second phase discharge path, the first phase discharge path and the second phase discharge path are used to connect a power supply and transmit electricity outputted when the power supply is discharged, and, the detection unit is used to form a detection loop for the first phase discharge path and the second phase discharge path when the power supply is discharged. The sampling unit is electrically connected to the detection unit and is used to separately collect, from the detection loop, a first detected voltage of the first phase discharge path and a second detected voltage of the second phase discharge path. The signal processing unit is connected to the sampling unit, and is used to asynchronously receive the first detected voltage and the second detected voltage from the sampling unit, and determine the electric-leakage characteristics of the power supply based on the first detected voltage and the second detected voltage.
Optionally, the detection unit includes a first detection circuit and a second detection circuit, wherein the first detection circuit is connected between the first phase discharge path and a low-voltage ground to form the detection loop, and the second detection circuit is connected between the second phase discharge path and the low-voltage ground to form the detection loop. The sampling unit is used to collect the first detected voltage from the first detection circuit and collect the second detected voltage from the second detection circuit.
Optionally, the first detection circuit includes a first detection voltage-stabilization module, a first unidirectional conduction module, and a sampling module, the first detection voltage-stabilization module, the first unidirectional conduction module, and the sampling module are sequentially connected in series between the first phase discharge path and the low-voltage ground to form the detection loop. The second detection circuit includes a second detection voltage-stabilization module and a second unidirectional conduction module, the second detection voltage-stabilization module, the second unidirectional conduction module, and the sampling module are sequentially connected in series between the second phase discharge path and the low-voltage ground to form a detection loop.
Optionally, the first detection voltage-stabilization module includes a first switch, the first unidirectional conduction module includes a first diode, and the sampling module includes a first resistor, a sampling node, and a sampling resistor. The first switch, the first diode, the first resistor, and the sampling resistor are sequentially connected in series between the first phase discharge path and the low-voltage ground to form the detection loop, an anode of the first diode is connected to the first switch, a cathode of the first diode is connected to the first resistor, and the sampling node is a node between the first resistor and the sampling resistor. The second detection voltage-stabilization module includes a second switch, the second unidirectional conduction module includes a second diode, the second switch, the second diode, the first resistor, and the sampling resistor are sequentially connected in series between the second phase discharge path and the low-voltage ground to form a detection loop, an anode of the second diode is connected to the second switch, and a cathode of the second diode is connected to the first resistor. The sampling unit collects the first detected voltage and the second detected voltage from the sampling node.

Optionally, the first detection voltage-stabilization module includes a first detection voltage-stabilization capacitor, the first unidirectional conduction module includes a first diode, and the sampling module includes a first resistor, a sampling node, and a sampling resistor. The first detection voltage-stabilization capacitor, the first diode, the first resistor, and the sampling resistor are sequentially connected in series between the first phase discharge path and the low-voltage ground to form the detection loop. An anode of the first diode is connected to the first detection voltage-stabilization capacitor, a cathode of the first diode is connected to the first resistor, and the sampling node is a node between the first resistor and the sampling resistor. The second detection voltage-stabilization module includes a second detection voltage-stabilization capacitor, the second unidirectional conduction module includes a second diode, the second detection voltage-stabilization capacitor, the second diode, the first resistor, and the sampling resistor are sequentially connected in series between the second phase discharge path and the low-voltage ground to form a detection loop, an anode of the second diode is connected to the second detection voltage-stabilization capacitor, and a cathode of the second diode is connected to the first resistor. The sampling unit collects the first detected voltage and the second detected voltage from the sampling node.

Optionally, the sampling unit includes a differential operational amplifier, a second resistor, a third resistor, and a third capacitor, a positive-phase end of the differential operational amplifier is connected to the sampling node and is used to collect the first detected voltage and the second detected voltage from the sampling node. The second resistor and the third capacitor are connected in series between a reverse-phase end of the differential operational amplifier and a device ground, and the reverse-phase end of the differential operational amplifier is connected to an output end of the differential operational amplifier through the third resistor, and are used to increase or decrease the first detected voltage and the second detected voltage according to a preset proportion and output the first detected voltage and the second detected voltage from the output end of the differential operational amplifier.

Optionally, the detection unit is further connected to a third phase discharge path, and the power supply is a three-phase alternating current power supply and outputs, through the first phase discharge path, the second phase discharge path, and the third phase discharge path, currents with equal amplitudes, same frequencies, and the same phase differences.

Optionally, the detection unit includes a first detection circuit and a second detection circuit, and the first detection circuit is connected between the first phase discharge path and a device ground and is connected to the second phase discharge path by the device ground to form the detection loop. The second detection circuit is connected between the second phase discharge path and the device ground, and is connected to the first phase discharge path through the device ground to form the detection loop

Optionally, the first detection circuit includes a first detection voltage-stabilization module, a first path voltage-stabilization module, a first voltage division module, and a sampling module. The first detection voltage-stabilization module, the first voltage division module, and the sampling module are sequentially connected in series between the first phase discharge path and the device ground, and the first path voltage-stabilization module is connected between the second phase discharge path and the device ground to form the detection loop. The second detection circuit includes a second detection voltage-stabilization module, a second path voltage-stabilization module, and a second voltage division module. The second detection voltage-stabilization module, the second voltage division module, and the sampling module are sequentially connected in series between the second phase discharge path and the device ground, and the second path voltage-stabilization module is simultaneously connected between the first phase discharge path and the device ground to form the detection loop.

Optionally, the first detection voltage-stabilization module includes a first switch, the first voltage division module includes a first diode and a first resistor, the sampling module includes a sampling resistor and a sampling node, and the first path voltage-stabilization module includes a first path voltage-stabilization capacitor, the first switch, the first diode, the first resistor and the sampling resistor are sequentially connected in series between the first phase discharge path and the device ground, an anode of the first diode is connected to the first switch, a cathode of the first diode is connected to the first resistor, the sampling node is a node between the first resistor and the sampling resistor, and the first path voltage-stabilization capacitor is simultaneously connected between the device ground and the second phase discharge path to form the detection loop. The second detection voltage-stabilization module includes a second switch, the second voltage division module includes a second diode and a second resistor, and the second path voltage-stabilization module comprises a second path voltage-stabilization capacitor, the second switch, the second diode, the second resistor and the sampling resistor are sequentially connected in series between the second phase discharge path and the device ground, an anode of the second diode is connected to the second switch, a cathode of the second diode is connected to the second resistor, and the second path voltage-stabilization capacitor is simultaneously connected between the device ground and the first phase discharge path to form a detection loop. The sampling unit is used to collect the first detected voltage and the second detected voltage from the sampling node.

Optionally, the first detection voltage-stabilization module includes a first detection voltage-stabilization capacitor, the first path voltage-stabilization module includes a first path voltage-stabilization capacitor, the first voltage division module includes a first diode and a first resistor, and the sampling module includes a sampling node and a sampling resistor. The first detection voltage-stabilization capacitor, the first diode, the first resistor and the sampling resistor are sequentially connected in series between the first phase discharge path and the device ground, an anode of the first diode is connected to the first detection voltage-stabilization capacitor, a cathode of the first diode is connected to the first resistor, the sampling node is a node between the first resistor and the sampling resistor, and the first path voltage-stabilization capacitor is simultaneously connected between the device ground and the second phase discharge path to form a detection loop. The second detection voltage-stabilization module includes a second detection voltage-stabilization capacitor, the second voltage division module includes a second diode and a second resistor, and the second path voltage-stabilization module includes a second path voltage-stabilization capacitor; the second detection voltage-stabilization capacitor, the second diode, the second resistor and the sampling resistor are sequentially connected in series between the second phase discharge path and the device ground, an anode of the second diode is connected to the second detection voltage-stabilization capacitor, a cathode of the second diode is connected to the second resistor, and the second path voltage-stabilization capacitor is simultaneously connected between the device ground and the first phase discharge path to form a detection loop. The sampling unit is used to collect the first detected voltage and the second detected voltage from the sampling node.

Optionally, the sampling unit includes a voltage follower, a positive-phase end of the voltage follower is connected to the sampling node, and is used to collect the first detected voltage and the second detected voltage from the sampling node, and a reverse-phase end of the voltage follower is connected to an output end of the voltage follower, and are used to increase or decrease the collected first detected voltage and the second detected voltage according to a preset proportion, and output the collected first detected voltage and the second detected voltage from the output end of the voltage follower.

Optionally, the signal processing unit includes a clamping circuit and a digital signal processor , the clamping circuit is connected to the sampling unit and the digital signal processor, and is used to clamp the first detected voltage and the second detected voltage received from the sampling unit to a preset voltage range and output the first detected voltage and the second detected voltage to the digital signal processor. The digital signal processor receives the first detected voltage and the second detected voltage, and determines a leakage characteristic of the power supply based on the first detected voltage and the second detected voltage.

An embodiment of the present disclosure further discloses a method for detecting electric leakage, applied to the aforementioned device for detecting electric leakage or electric vehicle. The specific steps include: when the power supply is positively discharged through the first phase discharge path, the first detection circuit is conducted to control the sampling unit such that the first detected voltage is collected from the first detection circuit. When the power supply is positively discharged through the second phase discharge path, the second detection circuit is conducted to control the sampling unit to collected a second detected voltage from the second detection circuit. The voltage difference between the first detected voltage and the second detected voltage is compared with a threshold voltage, and determine that a electric-leakage fault occurs in the power supply when the voltage difference is greater than the threshold voltage.

An embodiment of the present disclosure also discloses a vehicle, includes the aforementioned device for detecting electric leakage, the power supply is connected to a first phase discharge path and a second phase discharge path, and the power supply is discharged through the first phase discharge path and the second phase discharge path and outputs an alternating current, and the device for detecting electric leakage is used to perform electric-leakage detection on the first phase discharge path and the second phase discharge path when the power supply is discharged.

In comparison with the prior art, the device for detecting electric leakage provided by the present disclosure establishes a electric-leakage detection loop for the first phase discharge path and the second phase discharge path of the power supply, respectively, so as to directly and quickly perform electric-leakage detection on the power supply discharge loop during power supply discharges, effectively avoids the defect of large impedance of the detection loop caused by directly arrange the device for detecting electric leakage between the high voltage loops of the power supply, effectively improving the reliability of electric-leakage detection of the power discharge loop, and greatly improving the insulation characteristic of the power supply AC output end. Further, when there is no leakage fault in the power supply discharge loop, the device for detecting electric leakage is in a low power consumption state, thereby reducing the consumption of electric energy, and the device for detecting electric leakage has low overall power consumption and a simple structure, thereby greatly reducing the use cost and production cost of the circuit.

## BRIEF DESCRIPTION OF THE DRAWINGS

In order to more clearly illustrate the technical solutions in the embodiments of this disclosure, the accompanying drawings required to be used in the embodiments are briefly described below, and obviously, the accompanying drawings in the following description are some embodiments of this disclosure, and for a person of ordinary skill in the art, other drawings may be obtained according to these accompanying drawings without creative efforts.

FIG. 1 is a schematic block diagram of a driving device according to a first embodiment of the present disclosure;

FIG. 2 is a circuit block diagram of the device for detecting electric leakage as shown in FIG. 1 according to a second embodiment of the present disclosure;

FIG. 3 is a schematic diagram of a module connection of the device for detecting electric leakage in FIG. 2;

FIG. 4 is an equivalent circuit diagram of the device for detecting electric leakage in FIG. 3;

FIG. 5 is an equivalent circuit diagram of the device for detecting electric leakage in FIG. 3 according to a third embodiment of the present disclosure;

FIG. 6 is a schematic diagram of connections between functional modules of the device for detecting electric leakage in FIG. 2 according to a fourth embodiment of the present disclosure;

FIG. 7 is an equivalent circuit diagram of the device for detecting electric leakage in FIG. 6;

FIG. 8 is an equivalent circuit diagram of the device for detecting electric leakage in FIG. 6 according to a fifth embodiment of the present disclosure; and

FIG. 9 is a flowchart of a method for detecting electric leakage according to a sixth embodiment of the present disclosure.

## DETAILED DESCRIPTION

To facilitate understanding of the present disclosure, the present disclosure will be described more fully hereinafter with reference to the accompanying drawings. Preferred embodiments of the present disclosure are shown in the accompanying drawings. However, the present disclosure may be implemented in many different forms and is not limited to the embodiments described herein. Rather, the purpose of providing these embodiments is to make the disclosure of the present disclosure more thorough and comprehensive.

The following description of the embodiments is provided with reference to the accompanying drawings to illustrate specific embodiments that can be implemented by the present disclosure. The serial numbers of the components themselves, such as " first ", " second ", etc., are only used to distinguish the described objects, and do not have any order or technical meaning. However, the terms " connect " and " couple " in this disclosure are not specifically described, and all include direct and indirect connections (coupling). Directional terms mentioned in the present disclosure, for example, " upper ", " lower ", " front ", " rear ", " left", " right ", " inner ", " outer ", " side ", etc., are merely directions referring to the accompanying drawings, and therefore, the directional terms used is for better, clearer description and understanding of the present disclosure, rather than indicating or implying that the apparatus or element referred to by the present disclosure must have a specific orientation, or be constructed and operated in a specific orientation, and therefore cannot be understood as a limitation to the present disclosure.

In the description of this disclosure, it should be noted that, unless otherwise clearly stated and limited, the terms "installation", "connection" and "coupling" should be understood in a broad sense. For example, the terms can be a fixed connection, a detachable connection, or integral connection; a mechanical connection; a direct connection, an indirect connection through an intermediate medium; or an internal connection between two components. For those of ordinary skill in the art, the specific meanings of the above terms in this disclosure can be understood on a case-by-case basis. It should be noted that the terms "first" , "second" , etc. in the description, claims, and drawings of this disclosure are used to distinguish different objects, rather than describing a specific sequence.

In addition, the terms "include", "can include", "comprise", or "can comprise" used in this disclosure indicate the existence of the corresponding disclosed functions, operations, elements, etc., and do not limit other one or more functions, operations, components, etc. Furthermore, the term "include" or "comprise" indicates the presence of the corresponding features, numbers, steps, operations, elements, components, or combinations thereof disclosed in the specification, but does not exclude the presence or addition of one or more other features, numbers, steps, operations, elements, parts, or combinations thereof, are intended to cover non-exclusive inclusion. In addition, when describing embodiments of the present disclosure, the use of "can" means "one or more embodiments of the present disclosure." Also, the term "exemplary" is intended to refer to an example or illustration.

Unless otherwise defined, all technical and scientific terms used herein have the same meaning as commonly understood by one of ordinary skill in the art to which this disclosure belongs. The terms used in the description of the present disclosure are merely for the purpose of describing specific implementations, and are not intended to limit the present disclosure.

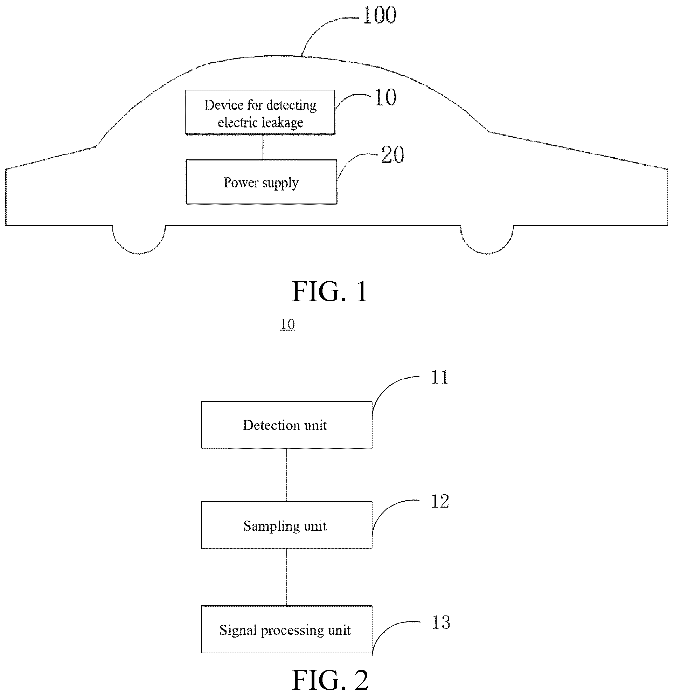

Referring to FIG. 1, FIG. 1 is a schematic block diagram of a driving device according to a first embodiment of the present disclosure. As shown in FIG. 1, the driving device 100 is a vehicle that can output electric energy outside the vehicle body, and includes a device 10 for detecting electric leakage and a power supply 20, the device 10 for detecting electric leakage is used to perform electric-leakage detection on the high voltage loop when the vehicle outputs electric energy to the outside.

Referring to FIG. 2, FIG. 2 is a circuit block diagram of a device for detecting electric leakage as shown in FIG. 1 according to a second embodiment of the present disclosure. As shown in FIG. 2, the device for detecting electric leakage 10 includes a detection unit 11, a sampling unit 12, and a signal processing unit 13.

The detection unit 11 is separately connected to the first phase discharge path L and the second phase discharge path N, the first phase discharge path L and the second phase discharge path N are used to connect to a power supply 20 and transmit electricity outputted when the power supply 20 is discharged, and the detection unit 11 is used to establish a detection loop for the first phase discharge path L and the second phase discharge path N when the power supply 20 is discharged.

The sampling unit 12 is electrically connected to the detection unit 11, and is configured to separately collect, from the detection loop, a first detected voltage $U_{LE}$ of the first phase discharge path L and/or a second detected voltage $U_{NE}$ of the second phase discharge path N.

The signal processing unit 13 is connected to the sampling unit 12, and is used to asynchronously receive the first detected voltage $U_{LE}$ and the second detected voltage $U_{NE}$ from the sampling unit 12, and determine the electric-leakage characteristics of the power supply, and indicates that a electric-leakage fault occurs in the power supply 20 when the difference between the first detected voltage $U_{LE}$ and the second detected voltage $U_{NE}$ is greater than the threshold voltage.

In an embodiment, the power supply 20 can also be a three-phase alternating current power supply, that is, the power supply 20 is a power supply includes three alternating current potentials with the same frequency, the same equal amplitudes, and a phase difference of 120° sequentially. Correspondingly, the power supply 20 output three currents with the same frequency, the same amplitudes, and the same phase differences of 120° through a first phase discharge path, a second phase discharge path, and a third phase discharge path respectively. When the power supply 20 outputs current through the three-phase discharge paths, the detection unit 11 is also connected to the first phase discharge path, the second phase discharge path, and the third phase discharge path, and performs corresponding detection.

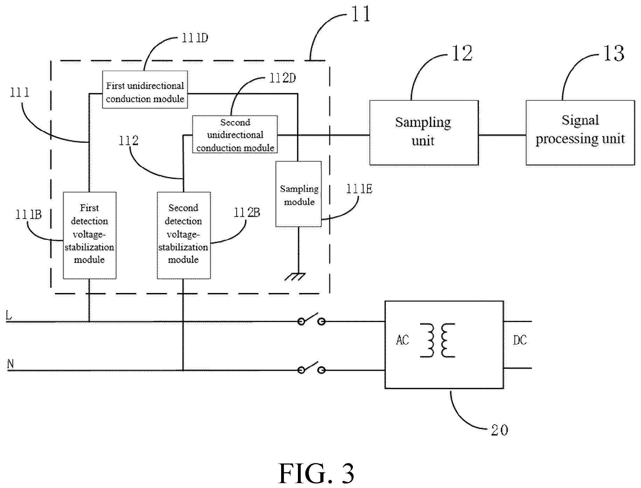

Referring to FIG. 3, FIG. 3 is a schematic diagram of a module connection of the device for detecting electric leakage in FIG. 2. As shown in FIG. 3, the detection unit 11 includes a first detection circuit 111 and a second detection circuit 112.

The first detection circuit 111 is connected between the first phase discharge path L and the low-voltage ground GND to form a detection loop for detecting the first detected voltage $U_{LE}$ of the first phase discharge path L, and the second detection circuit 112 is connected between the second phase discharge path N and the low voltage ground GND to form a detection loop for detecting the second detected voltage $U_{NE}$ of the second phase discharge path N.

When the power supply 20 outputs the alternating current and the first phase discharge path L is positively discharged, the first detection circuit 111 is conducted and the sampling unit 12 detects the first detected voltage $U_{LE}$ from the first detection circuit 111; when the power supply 20 outputs the alternating current and the second phase discharge path N is positively discharged, the second detection circuit 112 is conducted, and the sampling unit 12 detects the second detected voltage $U_{NE}$ from the second detection circuit 112.

The first detection circuit 111 includes a first detection voltage-stabilization module 111B, a sampling module 111E, and a first unidirectional conduction module 111D. The first detection voltage-stabilization module 111B, the first unidirectional conduction module 111D, and the sampling module 111E are sequentially connected in series between the first phase discharge path L and the low-voltage ground GND to form the detection loop

The second detection circuit 112 includes a second detection voltage-stabilization module 112B and a second unidirectional conduction module 112D. The second detection voltage-stabilization module 112B, the second unidirectional conduction module 112D, and the sampling module 111E are sequentially connected in series between the second phase discharge path N and the low-voltage ground GND to form the detection loop .

The sampling unit 12 is electrically connected to the detection unit 11, and the detection unit 11 is used to collect, from the detection loop, a first detected voltage $U_{LE}$ of the first phase discharge path L and/or a second detected voltage $U_{NE}$ of the second phase discharge path N.

The signal processing unit 13 is connected to the sampling unit 12, and is used to asynchronously receive the first detected voltage and the second detected voltage from the sampling unit 12, and determine the electric-leakage characteristics of the power supply and indicates that a electric-leakage fault occurs in the power supply 20 when the difference between the first detected voltage $U_{LE}$ and the second detected voltage $U_{NE}$ is greater than the threshold voltage.

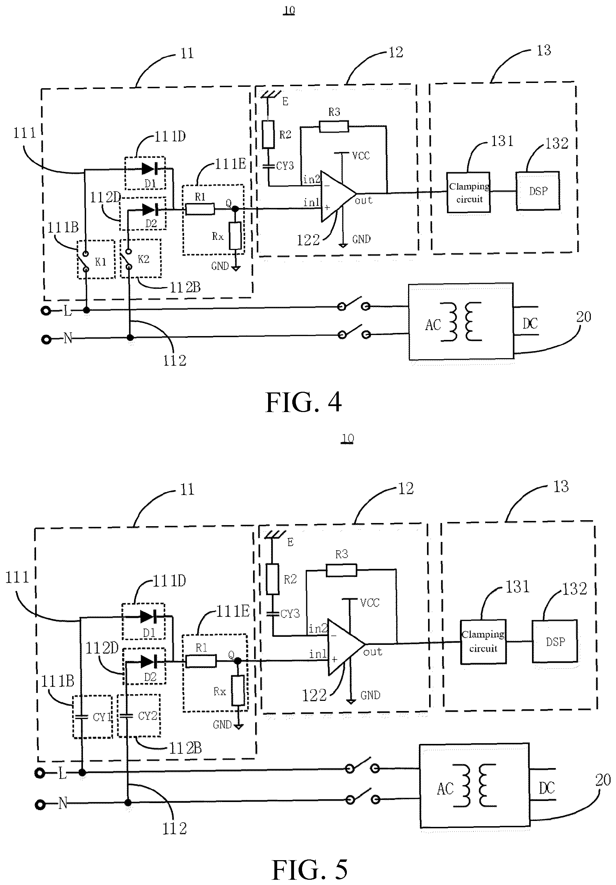

Referring to FIG. 4, FIG. 4 is an equivalent circuit diagram of the device for detecting electric leakage in FIG. 3. As shown in FIG. 4, the first detection voltage-stabilization module 111B includes a first switch K1, the first unidirectional conduction module 111D includes a first diode D1, and the sampling module 111E includes a first resistor R1, a sampling node Q, and a sampling resistor Rx. The first switch K1, the first diode D1, the first resistor R1 and the sampling resistor Rx are sequentially connected in series between the first phase discharge path L and the low-voltage ground GND to form the detection loop, an anode of the first diode D1 is connected to the first switch K1, the cathode of the first diode D1 is connected to the first resistor R1, and the sampling node Q is disposed between the first resistor R1 and the sampling resistor Rx to collect the first detected voltage $U_{LE}$ by the sampling unit 12 .

The second detection voltage-stabilization module 112B includes a second switch K2, the second unidirectional conduction module 112D includes a second diode D2, the second switch K2 and the second diode D2, the first resistor R1 and the sampling resistor Rx are sequentially connected in series between the second phase discharge path N and the low-voltage ground GND to form the detection loop, and an anode of the second diode D 2 is connected to the second switch K2, and a cathode of the second diode D2 is connected to the first resistor R1, the sampling unit 12 collects the second detected voltage $U_{NE}$ of the second phase discharge path N from the sampling node Q.

The sampling unit 12 includes a differential operational amplifier 122, a third capacitor CY3, a second resistor R2 and a third resistor R3. The third resistor R3 is connected between the reverse-phase end in2 of the differential operational amplifier 122 and the output end, out, of the differential operational amplifier 122. The second resistor R2 and the third capacitor CY3 is connected in series to the device ground E and a reverse-phase end in2 of the differential operational amplifier 122. A positive-phase end in1 of the differential operational amplifier 122 is connected to the sampling node Q, the differential operational amplifier 122 respectively collects the first detected voltage $U_{LE}$ and the second detected voltage $U_{NE}$ through the sampling node Q.

When the voltage of the first phase discharge path L is greater than the voltage of the second phase discharge path N, the differential operational amplifier 122 detects the first detected voltage $U_{LE}$ of the first phase discharge path L through the first detection circuit 111. When the voltage of the second phase discharge path N is greater than the voltage of the first phase discharge path L, the differential operational amplifier 122 detects the second detected voltage $U_{NE}$ of the second phase discharge path N through the second detection circuit 112

When the voltage of the first phase discharge path L is greater than the voltage of the second phase discharge path N, the positive-phase end in1 of the differential operational amplifier 122 is connected to the sampling node Q and is connected to the first phase discharge path L by the first detection circuit 111 , the first detected voltage $U_{LE}$ is collected from the sampling node Q, and the reverse-phase end in2 is connected to the device ground E through a third detection circuit, where the third detection circuit includes a second resistor R2 and a third capacitor CY3. When the circuit operates, the positive output passes through the first switch K1, the first diode D1, and the first resistor R1 to the positive-phase end in1 of the differential operational amplifier 122, and the negative input passes through the device ground E, the second resistor R2, the third capacitor CY3 to the reverse-phase end in2, and then the first detected voltage $U_{LE}$ is output from the output end, out, of the differential operational amplifier 122.

When the voltage of the second phase discharge path N is greater than the voltage of the first phase discharge path L, the positive-phase end in1 of the differential operational amplifier 122 is connected to the sampling node Q and is connected to the second phase discharge path N by the second detection circuit 112, the second detected voltage $U_{NE}$ is collected from the sampling node Q, and the reverse-phase end in2 is connected to the device ground E through the third detection circuit. When the working circuit operates, the positive output passes through the second switch K2, the second diode D2, and the first resistor R1 to the positive-phase end in1 of the differential operational amplifier 122, and the negative input passes through the device ground E, the second resistor R2 and the third capacitor CY3 to the reverse-phase end in2, and then the second detected voltage $U_{NE}$ is output from the output end, out, of the differential operational amplifier 122.

The differential operational amplifier 122 transmits the collected first detected voltage $U_{LE}$ and the second detected voltage $U_{NE}$ to the signal processing unit 13 through the output end, out.

The signal processing unit 13 includes a clamping circuit 131 and a digital signal processor (DSP) 132. The clamping circuit 131 is connected to the output end, out, of the differential operational amplifier 122 and the digital signal processor 132, and is used to adjust the received voltage values of the first detected voltage $U_{LE}$ and the second detected voltage $U_{NE}$ in a preset range. The digital signal processor 132 is used to compare the first detected voltage $U_{LE}$ and the second detected voltage $U_{NE}$ in digital form. When the difference between the first detected voltage $U_{LE}$ and the second detected voltage $U_{NE}$ is greater than the preset threshold, it indicates that a electric-leakage fault occurs in the power supply 20.

The device for detecting electric leakage disclosed in this embodiment can meet the requirements of the national standard "GB 18384.2020 Electric Vehicles Safety Requirements" that the alternating current discharge path, that is, the insulation resistance between the first phase discharge path L and the second phase discharge path N is $\geq 10M\Omega$.

Referring to FIG. 5, FIG. 5 is an equivalent circuit diagram of the device for detecting electric leakage in FIG. 3, provided by the third embodiment of the present disclosure. As shown in FIG. 5, the first detection voltage-stabilization module 111B includes a first detection voltage-stabilization capacitor CY1, the first unidirectional conduction module 111D includes a first diode D1, and the sampling module 111E includes a first resistor R1, a sampling node Q, and a sampling resistor Rx. The first detection stabilizing capacitor CY1, the first diode D1, the first resistor R1 and the sampling resistor Rx are sequentially connected in series to the first phase discharge path L and the low-voltage ground terminal GND to form the detection loop. An anode of the first diode D1 is connected to the first detection voltage-stabilization capacitor CY1, a cathode of the first diode D1 is connected to the first resistor R1, and the sampling node Q is a node between the first resistor R1 and the sampling resistor Rx for the sampling unit 12 to collect the first detected voltage $U_{LE}$.

The second detection voltage-stabilization module 112B includes a second detection voltage-stabilization capacitor CY2, and the second unidirectional conduction module 112D includes a second diode D2. The second detection voltage-stabilization capacitor CY2, the second diode D2, the first resistor R1 and the sampling resistor Rx are sequentially connected in series to the second phase discharge path N and the low-voltage ground GND to form a detection loop, an anode of the second diode D2 is connected to the second detection voltage-stabilization capacitor CY2, and a cathode of the second diode D2 is connected to the first resistor R1. The sampling unit 12 collects the second detected voltage $U_{NE}$ of the second phase discharge path N through the sampling node Q..

The sampling unit 12 includes a differential operational amplifier 122, a third capacitor CY3, a second resistor R2 and a third resistor R3. The third resistor R3 is connected between the reverse-phase end in2 of the differential operational amplifier 122 and the output end, out, of the differential operational amplifier 122. The second resistor R2 and the third capacitor CY3 are connected in series to a device ground E and a reverse-phase end in2 of the differential operational amplifier 122. The positive-phase end in1 of the differential operational amplifier 122 is connected to the sampling node Q, the differential operational amplifier 122 respectively collect the first detected voltage $U_{LE}$ and the second detected voltage $U_{NE}$ by the sampling node Q.

When the voltage of the first phase discharge path L is greater than the voltage of the second phase discharge path N, the differential operational amplifier 122 detects the first detected voltage $U_{LE}$ of the first phase discharge path L through the first detection circuit 111. When the voltage of the second phase discharge path N is greater than the voltage of the first phase discharge path L, the differential operational amplifier 122 detects the second detected voltage $U_{NE}$ of the second phase discharge path N through the second detection circuit 112.

When the voltage of the first phase discharge path L is greater than the voltage of the second phase discharge path N, the positive-phase end in1 of the differential operational amplifier 122 is connected to the sampling node Q and is connected to the first phase discharge path L through the first detection circuit 111, collecting the first detected voltage $U_{LE}$ from the sampling node Q, and the reverse-phase end in2 is connected to the device ground E by a third detection circuit, where the third detection circuit includes a second resistor R2 and a third capacitor CY3. When the circuit operates, the positive output passes through the first detection voltage-stabilization capacitor CY1, the first diode D1, and the first resistor R1 to the positive-phase end in1 of the differential operational amplifier 122, the negative input passes through the device ground E and the second resistor R2 and the third capacitor CY3 are connected to the reverse-phase end in2, and then the first detected voltage $U_{LE}$ is outputted from the output end out of the differential operational amplifier 122.

When the voltage of the second phase discharge path N is greater than the voltage of the first phase discharge path L, the positive-phase end in1 of the differential operational amplifier 122 is connected to the sampling node Q and is connected to the second phase discharge path N through the second detection circuit 112, the second detected voltage $U_{NE}$ is collected from the sampling node Q, and the reverse-phase end in2 is connected to the device ground E by the third detection circuit. When the circuit operates, the positive output passes through the second detection voltage-stabilization capacitor CY2, the second diode D2, and the first resistor R1 to the positive-phase end in1 of the differential operational amplifier 122, the negative input passes through the device ground E, the resistor R2 and the third capacitor CY3 to the reverse-phase end in2, and then the second detected voltage $U_{NE}$ is output from the output end, out, of the differential operational amplifier 122.

The differential operational amplifier 122 transmits the collected first detected voltage $U_{LE}$ and the second detected voltage $U_{NE}$ to the signal processing unit 13 through the output end, out.

The signal processing unit 13 includes a clamping circuit 131 and a digital signal processor (DSP) 132. The clamping circuit 131 is connected between the output end, out, of the differential operational amplifier 122 and the digital signal processor 132, and is used to adjust the received voltage values of the first detected voltage $U_{LE}$ and the second detected voltage $U_{NE}$ in a preset range. The digital signal processor 132 is used to compare the first detected voltage $U_{LE}$ and the second detected voltage $U_{NE}$ in digital form. When the difference between the first detected voltage $U_{LE}$ and the second detected voltage $U_{NE}$ is greater than the preset threshold, it indicates that a electric-leakage fault occurs in the power supply 20.

It can be seen from the virtual short characteristic of an operational amplifier that the voltages of the positive-phase end in1 of the differential operational amplifier 122 and the reverse-phase end in2 of the differential operational amplifier 122 are equal. The resistances of the third resistor R3 and the sampling resistor Rx are equal to the resistance of the feedback resistor Rf of the differential operational amplifier, that is, Rx=R3=Rf, the resistance values of the first resistor R1 and the second resistor R2 are equal, both are R, that is, R1=R2=R, the first detection voltage-stabilization capacitor CY1, the second detection voltage-stabilization capacitor CY2 and the third capacitor CY3 are equal, that is, CY1=CY2=CY3, then the differential operational amplifier 122 outputs a common mode voltage: $U_{LE}=(U_L-U_E)*Rf/R$.

When the voltage of the second phase discharge path N is greater than the voltage of the first phase discharge path L, the second detection circuit 112 is conducted and detects the second detected voltage $U_{NE}$ , $U_{NE}=(U_R-U_E)*Rf/R$.

When there is no insulation failure, that is, no electric-leakage, $U_{LE}{\approx}U_{NE}$.

"GB/T18384-2020 Electric Vehicles Safety Requirements" sets requirements for electric-leakage of new energy electric vehicles: at the maximum operating voltage, the minimum value of the insulation resistance of the alternating current circuit should be greater than 500Ω/V, and an effective value of the maximum operating voltage is 220V. The national standard requires that the alternating current side insulation resistance should be≥220V*500Ω/V=110kΩ, therefore, when the equivalent insulation resistance to the vehicle body of the first phase discharge path L or the second phase discharge path N ≤ 110kΩ, an alarm indication must be provided, and simultaneously, the vehicle stops discharging.

When a electric-leakage fault occurs in the first phase discharge path L relative to the ground and/or the second phase discharge path N relative to the ground, if the insulation resistance RL of the first phase discharge path L relative to the device ground decreases, the first detected voltage $U_{LE}$ decreases, so that a voltage UL of the first phase discharge path L relative to the ground decreases. Simultaneously, a large voltage difference appears between the voltage $U_L$ of the first phase discharge path L relative to the ground, and a voltage $U_N$ of the second phase discharge path N relative to the ground. When a deviation value of the common mode voltage is detected to reach a certain threshold M, that is, $|U_{LE} - U_{NE}|$ >M, an electric-leakage fault is reported and the discharge is ended.

The deviation value threshold M of the common mode voltage is determined by connecting a 110kΩ resistor in parallel to a path between the first phase discharge path L or the second phase discharge path N of the whole vehicle and the vehicle body of the driving device 100 and performing software matching. The threshold M can also be adjusted according to the specific needs of the driving device 100, and is not limited in this disclosure.

The device 10 for detecting electric leakage provided in this embodiment can make the insulation resistance between the alternating current ports of the power supply 20, that is, the first phase discharge path L and the second phase discharge path N, greater than or equal to 20 MΩ while ensuring detection accuracy.

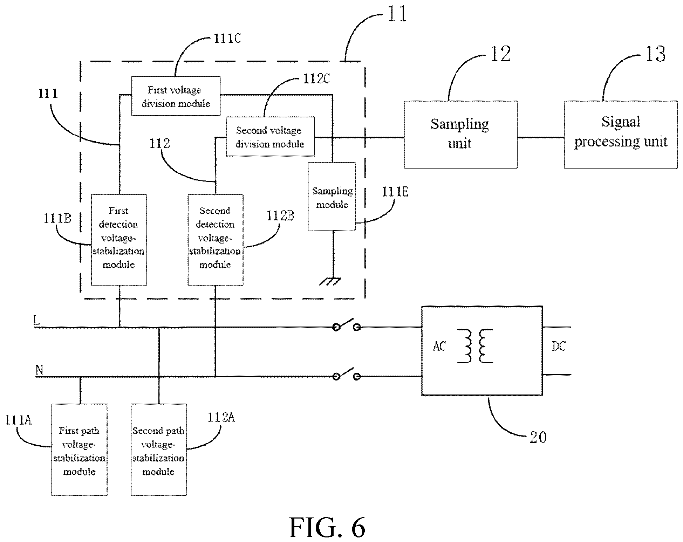

Referring to FIG. 6, which is a schematic connection diagram of functional modules of the device for detecting electric leakage in FIG. 2 disclosed in the fourth embodiment of the present disclosure. As shown in FIG. 6, the power supply 20 converts the received direct current DC into alternating current AC and outputs the electric energy to the electrical device outside the vehicle body through the first phase discharge path L and the second phase discharge path N.

The detection unit 11 includes a first detection circuit 111 and a second detection circuit 112.

The first detection circuit 111 is connected between the first phase discharge path L and the device ground E and is connected to the second phase discharge path N by the device ground E to form a detection loop for detecting the common mode voltage between the first phase discharge path L and the device ground terminal E. The device ground E is connected to the earth by the vehicle body of the driving device 100.

The second detection circuit 112 is connected between the second phase discharge path N and the device ground E and is connected to the first phase discharge path L by the device ground E to form a detection loop for detecting the common mode voltage between the second phase discharge path N and the device ground E, that is, the second detected voltage $U_{NE}$.

The current output by the power supply 20 is an alternating current. When the first phase discharge path L is positively discharged, the first detection circuit 111 is conducted, and the sampling unit 12 detects the first detected voltage $U_{LE}$ from the first detection circuit. When the second phase discharge path N is positively discharged, the second detection circuit 112 is conducted, and the sampling unit 12 detects the second detected voltage $U_{NE}$ from the second detection circuit 112.

The first detection circuit 111 includes a first path voltage-stabilization module 111A, a first detection voltage-stabilization module 111B, a first voltage division module 111C and a sampling module 111E. The first detection voltage-stabilization module 111B, the first voltage division module 111C and the sampling module 111E are sequentially connected in series between the first phase discharge path L and the device ground E, while the first path voltage-stabilization module 111A is simultaneously connected between the second phase discharge path and the device ground E to form a detection loop.

When the first detection circuit 111 is conducted, the first detection voltage-stabilization module 111B is used to maintain the stability of the voltage received by the first detection circuit 111 from the first phase discharge path L. The first path voltage-stabilization module 111A is used to maintain the stability of the voltage transmitted to the second phase discharge path N by the first detection circuit 111. The first voltage division module 111C is used to divide the voltage in the first detection circuit 111 and simultaneously provide a unidirectional conduction function from the first phase discharge path L to the device ground E. The sampling module 111E is used to provide the sampling unit 12 with the first detected voltage $U_{LE}$.

The second detection circuit 112 includes a second path voltage-stabilization module 112A, a second detection voltage-stabilization module 112B and a second voltage division module 112C. The second detection voltage-stabilization module 112B, the second voltage division module 112C and the sampling module 111E are sequentially connected in series between the second phase discharge path N and the device ground E. Simultaneously, the second path voltage-stabilization module 112A is connected between the first phase discharge path L and the equipment ground E to form a detection loop.

When the second detection circuit 112 is conducted, the second detection voltage-stabilization module 112B is used to maintain the stability of the voltage received by the second detection circuit 112 from the second phase discharge path N. The second path voltage-stabilization module 112A is used to maintain the stability of the voltage transmitted to the first phase discharge path by the second detection circuit 112. The second voltage division module 112C is used to divide the voltage in the second detection circuit 112 and simultaneously provide a unidirectional conduction function from the second phase discharge path N to the device ground E.

The sampling unit 12 is electrically connected to the detection unit 11, and is used to collect the first detected voltage $U_{LE}$ of the first phase discharge path L and/or the second detected voltage $U_{NE}$ of the second phase discharge path N from the detection loop,

The signal processing unit 13 is connected to the sampling unit 12 and is used to asynchronously receive the first detected voltage $U_{LE}$ and the second detected voltage $U_{NE}$ from the sampling unit 12 and determine the electric-leakage characteristics of the power supply 20. When the voltage difference between the first detected voltage $U_{LE}$ and the second detected voltage $U_{LE}$ is greater than the threshold voltage, it indicates that a electric-leakage fault occurs in the power supply 20.

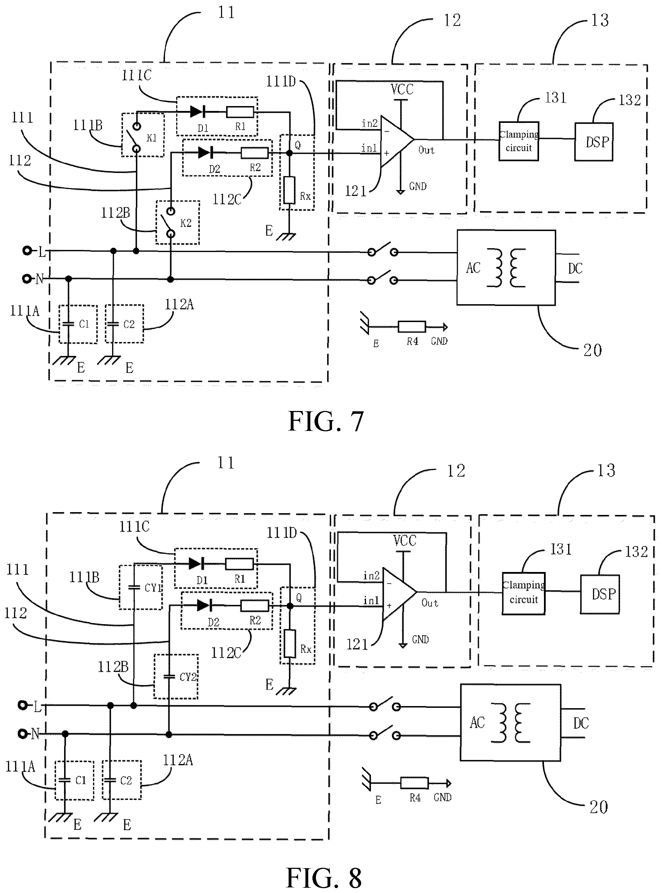

Please also refer to Figure 7, which is an equivalent circuit diagram of the device for detecting electric leakage in Figure 6. As shown in Figure 7, in the first detection circuit 111, the first path voltage-stabilization module 111A includes a first path voltage-stabilization capacitor C1, the first detection voltage-stabilization module 111B includes a first switch K1, and the first voltage division module 111C includes the first diode D1 and the first resistor R1, the sampling module 111E includes a sampling node Q and a sampling resistor Rx. Among them, the first switch K1, the first diode D1, the first resistor R1 and the sampling resistor Rx are connected in series between the first phase discharge path L and the device ground E, and the anode of the first diode D1 is connected to the first phase discharge path L and the device ground E. A switch K1, the cathode of the first diode D1 is connected to the first resistor R1, the sampling node Q is located at the node between the first resistor R1 and the sampling resistor Rx, and the first path voltage-stabilization capacitor C1 is connected to the second phase discharge path Between N and the device ground E, the first detection circuit 111 forms a common mode voltage detection loop.

The first switch K1 is connected between the first phase discharge path L and the first diode D1, and is used to control the execution detection and stop detection of the first detection circuit 111. The sampling resistor Rx is connected between the first resistor R1 and the device ground E, and is used to provide a voltage sampling point for the sampling unit 12. The sampling node Q is set between the first resistor R1 and the sampling resistor Rx. The sampling unit 12 is connected to the sampling node Q and is used to collect the voltage of the sampling resistor Rx when the first detection circuit 111 detects the common mode voltage of the first phase discharge path L. The voltage value is also the first detected voltage $U_{LE}$.

In the second detection circuit 112, the second path voltage-stabilization module 112A includes a second path voltage-stabilization capacitor C2, the second detection voltage-stabilization module 112B includes a second switch K2, and the second voltage division module includes a second diode D2 and second resistor R2. The second switch K2, the second diode D2 and the second resistor R2 are sequentially connected in series between the second phase discharge path N and the sampling node Q. The anode of the second diode D2 is connected to the second switch K2, the cathode of the diode D2 is connected to the second resistor R2, and the second path voltage-stabilization capacitor C2 is connected between the first phase discharge path L and the device ground E, so that the detection loop is formed among the second phase discharge path N, the second switch K2, the second diode D2, the second resistor R2, the sampling resistor Rx, the equipment ground E, the second path voltage-stabilization capacitor C2 and the first phase discharge path L. The sampling unit 12 obtains the second detected voltage $U_{NE}$ by the voltage of the sampling node Q.

The sampling unit 12 includes a voltage follower 121. A positive-phase end in1 of the voltage follower 121 is connected to the sampling node Q, a reverse-phase end in2 of the voltage follower 121 is connected to an output end, out, of the voltage follower 121, and the output end, out, is connected to the signal processing unit 13 for collecting the first detected voltage $U_{LE}$ and the second detected voltage $U_{NE}$, and the output end, out, transmits the first detected voltage $U_{LE}$ and the second detected voltage $U_{NE}$ to the signal processing unit 13.

The signal processing unit 13 includes a clamping circuit 131 and a digital signal processor (DSP) 132. The clamping circuit 131 is connected between the output end, out, of the voltage follower 121 and the digital signal processor 132, and is used to clamp the received voltage values of the first detected voltage $U_{LE}$ and the second detected voltage $U_{NE}$ to a preset voltage range. The digital signal processor 132 is used to receive the first detected voltage $U_{LE}$ and the second detected voltage $U_{NE}$ in digital form, and compare the first detected voltage $U_{LE}$ and the second detected voltage $U_{NE}$ in digital form. When the difference between the voltage $U_{LE}$ and the second detected voltage $U_{NE}$ is greater than the preset threshold, it indicates that an electric-leakage fault occurs in the power supply 20.

When the power supply 20 discharges through the first phase discharge path L and the second phase discharge path N, if no electric-leakage fault occurs, the common mode voltage between the first phase discharge path L and the device ground E is the same as the common mode voltage between the second phase discharge path N and the device ground E. simultaneously, no current flows through the detection unit 11 in the device 10 for detecting electric leakage, and the sampling unit 12 does not need to collect the first detected voltage $U_{LE}$ or the second detected voltage $U_{LE}$ from the sampling node, the signal processing unit 13 does not need to perform determination, and the device 10 for detecting electric leakage as a whole is in a low power consumption state.

When there is a voltage difference between the common mode voltage between the first phase discharge path L and the device ground E, and the common mode voltage between the second phase discharge path N and the device ground E, the detection unit 11 detects the first detected voltage $U_{LE}$ by the first detection circuit 111 and/or the second detected voltage $U_{NE}$ by the second detection circuit 112. The sampling unit 12 and the signal processing unit 13 then perform the subsequent detection and determination in sequence.

Specifically, when the driving device 100 turns on the discharge function, that is, supplies power to the electrical device outside the vehicle body, the power supply 20 inverts the direct current into alternating current. The first switch K1 and the first diode D1 in the first detection circuit 111, the first resistor R1, the sampling resistor Rx and the first path voltage-stabilization capacitor C1 form the detection loop between the first phase discharge path L and the second phase discharge path N. The voltage follower 121 in the sampling unit 12 collects the first detected voltage $U_{LE}$ from the sampling node Q and transmits the first detected voltage $U_{LE}$ to the clamping circuit 131. The clamping circuit 131 clamps the received first detected voltage $U_{LE}$ and transmits it to the digital signal processor 132.

Alternatively, in the second detection circuit 112, the second switch K2, the second diode D2, the second resistor R2, the sampling resistor Rx and the second path voltage-stabilization capacitor C2 from the detection loop between the second phase discharge path N and the first phase discharge path L. The voltage follower 121 in the sampling unit 12 collects the second detected voltage $U_{NE}$ from the sampling node Q and transmits the second detected voltage $U_{NE}$ to the clamping circuit 131. The clamping circuit 131 clamps the received second detected voltage $U_{NE}$ and transmits it to the digital signal processor 132.

Among them, the voltage follower 121 is connected to the low-voltage ground GND. A fourth resistor R4 is provided between the low-voltage ground GND and the device ground E. The potential between the low-voltage ground GND and the device ground E is the same, to avoid crosstalk between the low-voltage ground GND and device ground E.

The digital signal processor 132 compares the received first detected voltage $U_{LE}$ and/or the second detected voltage $U_{NE}$ in digital form. When the difference between the first detected voltage $U_{LE}$ and the second detected voltage $U_{NE}$ is greater than the preset threshold, it indicates that the power supply 20 has an electric-leakage fault. There is no need to specifically identify the first detected voltage $U_{LE}$ and the second detected voltage $U_{NE}$. When the digital signal processor 132 receives the first detected voltage $U_{LE}$ or the second detected voltage $U_{NE}$, it only needs to detect the first detected voltage $U_{LE}$ to obtain the second detected voltage $U_{NE}$, and then the difference between the first detected voltage $U_{LE}$ and the second detected voltage $U_{NE}$ can be calculated, or the first detected voltage $U_{LE}$ can be obtained through the second detected voltage $U_{NE}$, and then the difference between the first detected voltage $U_{LE}$ and the second detected voltage $U_{NE}$ can be calculated.

When there is no electric-leakage fault in the discharge circuits of the power supply 20, the device 10 for detecting electric leakage is in a low power consumption state. For example, the power supply 20 outputs 220V AC power through the first phase discharge path L and the second phase discharge path N, which is used to power external electric device. When no electric-leakage fault occurs, the common mode voltage between the first phase discharge path L and the equipment ground E is 110V, the common mode voltage between the second phase discharge path N and the device ground E is 110V, there is no voltage difference between the first phase discharge path L and the second phase discharge path N, there is no current flowing between the first detection circuit 111 and the second detection circuit 112, and the device for detecting electric leakage is in a low power consumption state.

When the sampling unit 12 collects the first detected voltage $U_{LE}$ through the first detection circuit 111 or the second detected voltage $U_{NE}$ through the second detection circuit 112, according to the alternating current characteristics, the signal processing unit 13 can calculate the second detected voltage $U_{NE}$ based on the first detected voltage $U_{LE}$, or the first detected voltage $U_{LE}$ can be calculated based on the second detected voltage $U_{NE}$, and then the voltage difference between the first detected voltage $U_{LE}$ and the second detected voltage $U_{NE}$ can be calculated.

For example, when a electric-leakage fault occurs, when the common mode voltage between the first phase discharge path L and the device ground E is 160V, based on the voltage between the first phase discharge path L and the device ground E, the signal processing unit 13 can calculate the common mode voltage between the second phase discharge path N and the device ground E, or when the common mode voltage between the second phase discharge path N and the device ground E collected by the sampling unit 12 is 60V, there is a voltage difference between the first phase discharge path L and the second phase discharge path N.

The first detection circuit 111 and the second detection circuit 112 are conducted at different time points respectively, the first detected voltage $U_{LE}$ and the second detected voltage $U_{NE}$ can be detected and sampled by the first detection circuit 111. The digital signal processing unit determines the difference between the first detected voltage $U_{LE}$ and the second detected voltage $U_{NE}$, if the difference is greater than the threshold voltage, it indicates that a electric-leakage fault occurs when the power supply 20 supplies power.

The device 10 for detecting electric leakage provided in this embodiment can make the insulation resistance between the alternating current ports of the power supply 20, that is, the first phase discharge path L and the second phase discharge path N, greater than or equal to 10 MΩ while ensuring detection accuracy.

Please refer to FIG. 8, which is an equivalent circuit diagram of the device for detecting electric leakage in FIG. 6 provided by the fifth embodiment of the present disclosure. As shown in Figure 8, in the first detection circuit 111, the first path voltage-stabilization module 111A includes a first path voltage-stabilization capacitor C1, the first detection voltage-stabilization module 111B includes a first detection voltage-stabilization capacitor CY1, the first voltage division module 111C includes a first diode D1 and a first resistor R1, and the sampling module 111E includes a sampling node Q and a sampling resistor Rx. Among them, the first detection voltage-stabilization capacitor CY1, the first diode D1, the first resistor R1 and the sampling resistor Rx are connected in series between the first phase discharge path L and the device ground E. The anode of the first diode D1 is connected to the first detection voltage-stabilization capacitor CY1, the cathode of the first diode D1 is connected to the first resistor R1, the sampling node Q is located between the first resistor R1 and the sampling resistor Rx, and the first path voltage-stabilization capacitor C1 is connected between the second phase discharge path N and the device ground E, the first detection circuit 111 forms a common mode voltage detection loop.

The second detection stabilizing capacitor CY2 is connected between the first phase discharge path L and the first diode D1 to increase the impedance in the detection loop and maintain voltage stability of the first detection circuit 111. The sampling resistor Rx is connected between the first resistor R1 and the device ground E, and is used to provide a voltage sampling point for the sampling unit 12. A sampling node Q is provided between the first resistor R1 and the sampling resistor Rx. The sampling unit 12 is connected to the sampling node Q and is used to collect the voltage of the sampling resistor Rx, that is, the first detected voltage $U_{LE}$ when the first detection circuit 111 detects the common mode voltage of the first phase discharge path L.

In the second detection circuit 112, the second path voltage-stabilization module 112A includes a second path voltage-stabilization capacitor C2, the second detection voltage-stabilization module 112B includes the second detection voltage-stabilization capacitor CY2, and the second voltage division module includes the second diode D2 and the second resistor R2. The second detection voltage-stabilization capacitor CY2, the second diode D2 and the second resistor R2 are connected sequentially in series between the second phase discharge path N and the sampling node Q, the anode of the second diode D2 is connected to the second detection voltage-stabilization capacitor CY2, the cathode of the second diode D2 is connected to the second resistor R2, and the sampling node Q is located between the first resistor R1 and the sampling resistor Rx. Simultaneously, the second path voltage-stabilization capacitor C2 is connected between the first phase discharge path L and the equipment ground E, so that the detection loop is formed among the second phase discharge path N, the second detection voltage-stabilization capacitor CY2, the second diode D2, the resistor R2, the sampling resistor Rx, the device ground E, the second path voltage-stabilization capacitor C2 and the first phase discharge path L. The sampling unit 12 obtains the second detected voltage $U_{NE}$ by collecting the voltage of the sampling node Q.

The capacitance value of the second path voltage-stabilization capacitor C2 and the second detection voltage-stabilization capacitor CY2 are equal, and the resistance value of the first resistor R1 is equal to the resistance value of the second resistor R2.

The sampling unit 12 includes a voltage follower 121. The positive-phase end in1 of the voltage follower 121 is connected to the sampling node Q, the reverse-phase end in2 of the voltage follower 121 is connected to the output end, out, of the voltage follower 121, and the output end, out, is connected to the signal processing unit 13 for collecting the first detected voltage $U_{LE}$ and the second detected voltage $U_{NE}$ from the sampling node Q, and the first detected voltage $U_{LE}$ and the second detected voltage $U_{NE}$ are transmitted to the signal processing unit 13.

The signal processing unit 13 includes a clamping circuit 131 and a digital signal processor (DSP) 132. The clamping circuit 131 is connected between the output end, out, of the voltage follower 121 and the digital signal processor 132, and is used to clamp the received voltage values of the first detected voltage $U_{LE}$ and the second detected voltage $U_{NE}$ in a preset range. The digital signal processor 132 is used to compare the first detected voltage $U_{LE}$ and the second detected voltage $U_{NE}$ in digital form. When a difference between the first detected voltage $U_{LE}$ and the second detected voltage $U_{NE}$ are greater than the preset threshold, it indicates that an electric-leakage fault occurs in the power supply 20.

Specifically, when the driving device 100 turns on the discharge function to supply power to electrical device outside the vehicle body, the power supply 20 inverts the direct current into alternating current, in the first detection circuit 111, the first detection voltage-stabilization capacitor CY1, the diode D1, the first resistor R1, the sampling resistor Rx and the first path voltage-stabilization capacitor C1 form a detection loop between the first phase discharge path L and the second phase discharge path N. The voltage follower 121 in the sampling unit 12 collects the first detected voltage $U_{LE}$ from the sampling node Q and transmits the first detected voltage $U_{LE}$ to the clamping circuit 131. The clamping circuit 131 clamps the received first detected voltage $U_{LE}$ and transmits it to the digital signal processor 132.

In the second detection circuit 112, the second detection voltage-stabilization capacitor CY2, the second diode D2, the second resistor R2, the sampling resistor Rx and the second path voltage-stabilization capacitor C2 form the detection loop between the second phase discharge path N and the first phase discharge path. The voltage follower 121 in the sampling unit 12 collects the second detected voltage $U_{NE}$ from the sampling node Q and transmits the second detected voltage $U_{NE}$ to the clamping circuit 131. The clamping circuit 131 clamps the received second detected voltage

$U_{NE}$ and transmits it to the digital signal processor 132. The digital signal processor 132 compares the received first detected voltage $U_{LE}$ and the second detected voltage $U_{NE}$ in digital form. When the difference between the first detected voltage $U_{LE}$ and the second detected voltage $U_{NE}$ is greater than the preset threshold, it indicates a electric-leakage fault occurs in the power supply 20.

The frequency of the alternating current AC outputs by the power supply 20 is $f_{AC}$ =50Hz, the impedance of the first voltage-stabilization capacitor C1 is $R_{C1}$ =1/(2 $\pi$ *$f_{AC}$*$C_{C1}$), and the impedance of the first detection voltage-stabilization capacitor CY1 is $R_{CY1}$=1/(2 $\pi$ *$f_{AC}$*$C_{CY1}$), the impedance of the second path voltage-stabilization capacitor C2 is $R_{C2}$=1/(2 $\pi$ *$f_{AC}$*$C_{C2}$), and the impedance of the second detection voltage-stabilization capacitor CY2 $R_{CY2}$=1/(2 $\pi$ *$f_{AC}$*$C_{CY2}$).

$$U_L=R_X/(R_{CY1}+R1+R_X)*U_{LE}, \quad U_N= R_X/(R_{CY2}+R2+R_X)*U_{NE}.$$

When the driving device 100 starts to discharge and there is no insulation fault, $U_{LE} \approx U_{NE}$,

$$Rx/(R1+Rx)*\{R_{C2}//(Rx+R1+R_{CY1})/[R_{C1}+R_{C2}//(Rx+R1+R_{CY1})]*U_{LN}\} \approx$$

$$Rx/(R2+Rx)*\{R_{C1}//(Rx+R2+R_{CY2})/[R_{C2}+R_{C1}//(Rx+R2+R_{CY2})]*U_{LN}\}.$$

$U_{LN}$ is the differential mode voltage between the first phase discharge path L and the second phase discharge path N.

"GB/T18384-2020 Electric Vehicles Safety Requirements" sets requirements for electric-leakage of new energy electric vehicles: at the maximum operating voltage, the minimum value of the insulation resistance of the alternating current circuit should be greater than 500$\Omega$/V, and an effective value of the maximum operating voltage is 220V. The national standard requires that the alternating current side insulation resistance should be $\geq$ 220V* 500$\Omega$/V=110k$\Omega$, therefore, when the equivalent insulation resistance to the vehicle body of the first phase discharge path L or the second phase discharge path N $\leq$ 110k$\Omega$, an alarm indication must be provided, and simultaneously, the vehicle stops discharging.

When a electric-leakage fault occurs at one end of the first phase discharge path L relative to the ground and/or the second phase discharge path N relative to the ground, if the insulation resistance RL of the first phase discharge path L relative to the device ground decreases, the first detected voltage $U_{LE}$ decreases, so the voltage UL at the L end of the first phase discharge path decreases. At this time, a large voltage difference will appear between the voltage UL at the L end of the first phase discharge path and the voltage UN at the N end of the second phase discharge path. , when it is detected that the deviation value of the common mode voltage reaches the voltage threshold M, that is, $|U_{LE}-U_{NE}|$>M, a electric-leakage fault is reported and the discharge ends. The specific common mode voltage difference threshold M needs to be matched based on the equivalent capacitance of the alternating current ports when the vehicle discharges, that is, the equivalent capacitance of the first path voltage-stabilization capacitor C1 and the second path voltage-stabilization capacitor C2 when the vehicle discharges. A 110 k$\Omega$ resistance is connected in parallel between the first phase discharge path L or the second phase discharge path N and the vehicle body of the driving device 100, and the common mode voltage difference threshold M matched through software.

The device 10 for detecting electric leakage provided in this embodiment can make the insulation resistance between the alternating current ports of the power supply 20, that is, between the first phase discharge path L and the second phase discharge path N, greater than or equal to 20 M$\Omega$ while ensuring detection accuracy.

By detecting the electric-leakage of the driving device through collecting the common mode voltage of the power supply discharge loop, it avoids setting the device for detecting electric leakage directly between the high-voltage circuit and the vehicle body of the driving device, improves the insulation performance of the whole vehicle, and meets the enterprise standard vehicle safety requirements. At the same time, when there is no electric-leakage fault in the power supply discharge loop, the device for detecting electric leakage is in a low power consumption state, which reduces the power consumption. The overall power consumption of the device for detecting electric leakage is low and the structure is simple, which greatly reduces the usage costs and production costs.

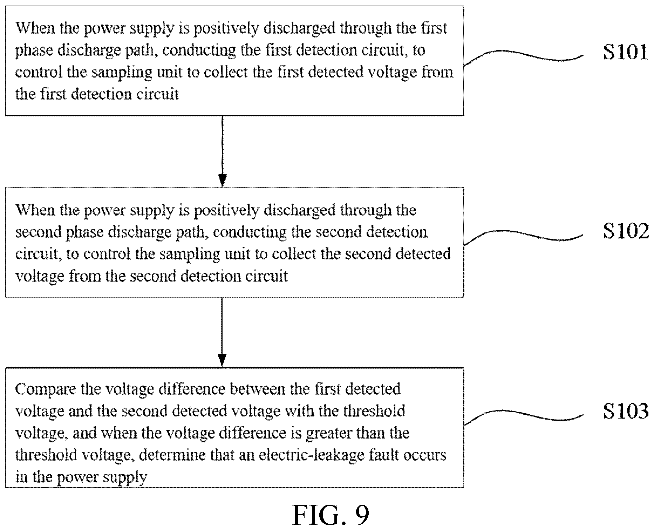

Referring to FIG. 9. FIG 9 is a flow chart of a method for detecting electric leakage provided by the sixth embodiment of the present disclosure. As shown in Figure 9, the method for detecting electric leakage can be applied to the aforementioned device for detecting electric leakage and driving device. The specific steps are:

In S101, when the power supply is positively discharged through the first phase discharge path, the first detection circuit is conducted, and the sampling unit is controlled to collect the first detected voltage from the first detection circuit.

When the power supply 20 inverts direct current into alternating current to supply power to the electrical device outside the vehicle body, when the first phase discharge path L is conducted, the first detection circuit 111 is conducted, and the sampling unit 12 can collect the first detected voltage $U_{LE}$ from the sampling node in the first detection circuit 111, and the first detected voltage $U_{LE}$ is the common mode voltage between the first phase discharge path L and the device ground E.

In S102, when the power source is positively discharged through the second phase discharge path, the second detection circuit is conducted, and the sampling unit is controlled to collect the second detected voltage from the second detection circuit..

When the second phase discharge path N is conducted, the second detection circuit 112 is conducted, the sampling unit 12 can collect the second detected voltage $U_{NE}$ from the sampling node in the second detection circuit 112, and the second detected voltage $U_{NE}$ is the common mode voltage between the second phase discharge path N and the device ground E.

In S103, compare the voltage difference between the first detected voltage and the second detected voltage with the threshold voltage. When the voltage difference is greater than the threshold voltage, it is determined that an electric-leakage fault occurs in the power supply.

The signal processing unit 13 compares the received first detected voltage $U_{LE}$ and the second detected voltage $U_{NE}$ with an internally preset threshold voltage. If the voltage difference between the first detected voltage $U_{LE}$ and the second detected voltage $U_{NE}$ is greater than the threshold voltage, it indicates that a electric-leakage fault occurs in the first phase discharge path L or the second phase discharge path N.

It should be understood that the application of the present disclosure is not limited to the above examples. Those of ordinary skill in the art can make improvements or changes based on the above descriptions. All these improvements and changes should fall within the protection scope of the appended claims of the present disclosure.

**Claims**

1. A device (10) for detecting electric leakage, comprising:

   a detection unit (11), the detection unit (11) being separately connected to a first phase discharge path and a second phase discharge path, the first phase discharge path and the second phase discharge path being configured to connect a power supply (20) and transmit electricity outputted when the power supply (20) is discharged, and the detection unit (11) being configured to establish a detection loop for the first phase discharge path and the second phase discharge path when the power supply (20) is discharged; and
   a sampling unit (12), electrically connected to the detection unit (11), and configured to separately collect, from the detection loop, a first detected voltage of the first phase discharge path and a second detected voltage of the second phase discharge path, and
   a signal processing unit (13), connected to the sampling unit (12), and configured to asynchronously receive the first detected voltage and the second detected voltage from the sampling unit (12), and determine the electric-leakage characteristics of the power supply (20) based on the first detected voltage and the second detected voltage.

2. The device (10) for detecting electric leakage according to claim 1, wherein

   the detection unit (11) comprises a first detection circuit (111) and a second detection circuit (112), and the first detection circuit (111) is connected between the first phase discharge path and a low-voltage ground to form the detection loop; and
   the second detection circuit (112) is connected between the second phase discharge path and the low-voltage ground to form the detection loop; and
   the sampling unit (12) is configured to collect the first detected voltage from the first detection circuit (111) and collect the second detected voltage from the second detection circuit (112).

3. The device (10) for detecting electric leakage according to claim 2, wherein the first detection circuit (111) comprises a first detection voltage-stabilization module (111B), a first unidirectional conduction module (111D) and a sampling module (111E), the first detection voltage-stabilization module (111B), the first unidirectional conduction module (111D) and the sampling module (111E) are sequentially connected in series between the first phase discharge path and the low-voltage ground to form the detection loop; and
   the second detection circuit (112) comprises a second detection voltage-stabilization module (112B) and a second unidirectional conduction module (112D), the second detection voltage-stabilization module (112B), the second unidirectional conduction module (112D) and the sampling module (111E) are sequentially connected in series between the second phase discharge path and the low-voltage ground to form the detection loop.

4. The device (10) for detecting electric leakage according to claim 3, wherein

the first detection voltage-stabilization module (111B) comprises a first switch, the first unidirectional conduction module (111D) comprises a first diode, and the sampling module (111E) comprises a first resistor, a sampling node and a sampling resistor;

the first switch, the first diode, the first resistor and the sampling resistor are sequentially connected in series between the first phase discharge path and the low-voltage ground to form the detection loop, an anode of the first diode is connected to the first switch, a cathode of the first diode is connected to the first resistor, and the sampling node is a node between the first resistor and the sampling resistor;

the second detection voltage-stabilization module (112B) comprises a second switch, the second unidirectional conduction module (112D) comprises a second diode, and the second switch, the second diode, the first resistor, and the sampling resistor are sequentially connected in series between the second phase discharge path and the low-voltage ground to form the detection loop; and an anode of the second diode is connected to the second switch, and a cathode of the second diode is connected to the first resistor; and

the sampling unit (12) collects the first detected voltage and the second detected voltage from the sampling node.

5. The device (10) for detecting electric leakage according to claim 3, wherein

the first detection voltage-stabilization module (111B) comprises a first detection voltage-stabilization capacitor, the first unidirectional conduction module (111D) comprises a first diode, and the sampling module (111E) comprises a first resistor, a sampling node and a sampling resistor;

the first detection voltage-stabilization capacitor, the first diode, the first resistor and the sampling resistor are sequentially connected in series between the first phase discharge path and the low-voltage ground to form the detection loop, an anode of the first diode is connected to the first detection voltage-stabilization capacitor, a cathode of the first diode is connected to the first resistor, and the sampling node is a node between the first resistor and the sampling resistor;

the second detection voltage-stabilization module (112B) comprises a second detection voltage-stabilization capacitor, the second unidirectional conduction module (112D) comprises a second diode, and the second detection voltage-stabilization capacitor, the second diode, the first resistor and the sampling resistor are sequentially connected in series between the second phase discharge path and the low-voltage ground to form a detection loop; and an anode of the second diode is connected to the second detection voltage-stabilization capacitor, and a cathode of the second diode is connected to the first resistor; and

the sampling unit (12) collects the first detected voltage and the second detected voltage from the sampling node.

6. The device (10) for detecting electric leakage according to claim 4 or 5, wherein the sampling unit (12) comprises a differential operational amplifier (122), a second resistor, a third resistor, and a third capacitor, wherein

a positive-phase end of the differential operational amplifier (122) is connected to the sampling node, and is configured to collect the first detected voltage and the second detected voltage from the sampling node; and the second resistor and the third capacitor are connected in series between a reverse-phase end of the differential operational amplifier (122) and a device ground, and the reverse-phase end of the differential operational amplifier (122) is connected to an output end of the differential operational amplifier (122) through the third resistor, and are configured to increase or decrease the first detected voltage and the second detected voltage according to a preset proportion and output the first detected voltage and the second detected voltage from the output end of the differential operational amplifier (122).

7. The device (10) for detecting electric leakage according to claim 1, wherein the detection unit (11) is further connected to a third phase discharge path, and the power supply (20) is a three-phase alternating current power supply and outputs, through the first phase discharge path, the second phase discharge path, and the third phase discharge path, currents with equal amplitudes, same frequencies, and the same phase differences.

8. The device (10) for detecting electric leakage according to claim 1, wherein the detection unit (11) comprises a first detection circuit (111) and a second detection circuit (112),

the first detection circuit (111) is connected between the first phase discharge path and a device ground, and is connected to the second phase discharge path by the device ground to form the detection loop; and
the second detection circuit (112) is connected between the second phase discharge path and the device ground, and is connected to the first phase discharge path through the device ground to form the detection loop.

9. The device (10) for detecting electric leakage according to claim 8, wherein the first detection circuit (111) comprises a first detection voltage-stabilization module (111B), a first path voltage-stabilization module (111A), a first voltage division module (111C) and a sampling module (111E), the first detection voltage-stabilization module (111B), the first voltage division module (111C) and the sampling module (111E) are sequentially connected in series between the first phase discharge path and the device ground, and the first path voltage-stabilization module (111A) is simultaneously connected between the second phase discharge path and the device ground to form the detection loop; and the second detection circuit (112) comprises a second detection voltage-stabilization module (112B), a second path voltage-stabilization module (112A), and a second voltage division module (112C), the second detection voltage-stabilization module (112B), the second voltage division module (112C) and the sampling module (111E) are sequentially connected in series between the second phase discharge path and the device ground, and the second path voltage-stabilization module (112A) is simultaneously connected between the first phase discharge path and the device ground to form the detection loop.

10. The device (10) for detecting electric leakage according to claim 9, wherein

the first detection voltage-stabilization module (111B) comprises a first switch, the first voltage division module (111C) comprises a first diode and a first resistor, the sampling module (111E) comprises a sampling resistor and a sampling node, and the first path voltage-stabilization module (111A) comprises a first path voltage-stabilization capacitor; and the first switch, the first diode, the first resistor, and the sampling resistor are sequentially connected in series between the first phase discharge path and the device ground, an anode of the first diode is connected to the first switch, a cathode of the first diode is connected to the first resistor, the sampling node is a node between the first resistor and the sampling resistor, and the first path voltage-stabilization capacitor is simultaneously connected between the device ground and the second phase discharge path to form the detection loop;

the second detection voltage-stabilization module (112B) comprises a second switch, the second voltage division module (112C) comprises a second diode and a second resistor, and the second path voltage-stabilization module (112A) comprises a second path voltage-stabilization capacitor; and the second switch, the second diode, the second resistor and the sampling resistor are sequentially connected in series between the second phase discharge path and the device ground, an anode of the second diode is connected to the second switch, a cathode of the second diode is connected to the second resistor, and the second path voltage-stabilization capacitor is simultaneously connected between the device ground and the first phase discharge path to form the detection loop; and

the sampling unit (12) is configured to collect the first detected voltage and the second detected voltage from the sampling node.

11. The device (10) for detecting electric leakage according to claim 9, wherein

the first detection voltage-stabilization module (111B) comprises a first detection voltage-stabilization capacitor, the first path voltage-stabilization module (111A) comprises a first path voltage-stabilization capacitor, the first voltage division module (111C) comprises a first diode and a first resistor, and the sampling module (111E) comprises a sampling node and a sampling resistor; and the first detection voltage-stabilization capacitor, the first diode, the first resistor and the sampling resistor are sequentially connected in series between the first phase discharge path and the device ground, an anode of the first diode is connected to the first detection voltage-stabilization capacitor, a cathode of the first diode is connected to the first resistor, the sampling node is a node between the first resistor and the sampling resistor, and the first path voltage-stabilization capacitor is simultaneously connected between the device ground and the second phase discharge path to form the detection loop;

the second detection voltage-stabilization module (112B) comprises a second detection voltage-stabilization capacitor, the second voltage division module (112C) comprises a second diode and a second resistor, and the second path voltage-stabilization module (112A) comprises a second path voltage-stabilization capacitor; and the second detection voltage-stabilization capacitor, the second diode, the second resistor, and the sampling resistor are sequentially connected in series between the second phase discharge path and the device ground, an anode of the second diode is connected to the second detection voltage-stabilization capacitor, a cathode of the second diode is connected to the second resistor, and the second path voltage-stabilization capacitor is simultaneously connected between the device ground and the first phase discharge path to form the detection loop; and

the sampling unit (12) is configured to collect the first detected voltage and the second detected voltage from the sampling node.

12. The device (10) for detecting electric leakage according to claim 10 or 11, wherein

the sampling unit (12) comprises a voltage follower (121), a positive-phase end of the voltage follower (121) is connected to the sampling node, and is configured to collect the first detected voltage and the second detected voltage from the sampling node, and a reverse-phase end of the voltage follower is connected to an output end of the voltage follower, and are configured to increase or decrease the collected first detected voltage and the second detected voltage according to a preset proportion, and output the collected first detected voltage and the second detected voltage from the output end of the voltage follower (121).

13. The device (10) for detecting electric leakage according to claim 1, wherein the signal processing unit (13) comprises a clamping circuit (131) and a digital signal processor (132), the clamping circuit (131) is connected to the sampling unit (12) and the digital signal processor (132), and is configured to clamp the first detected voltage and the second detected voltage received from the sampling unit (12) to a preset voltage range and output the first detected voltage and the second detected voltage to the digital signal processor (132); and
the digital signal processor (132) receives the first detected voltage and the second detected voltage, and determines a leakage characteristic of the power supply (20) based on the first detected voltage and the second detected voltage.

14. A method for detecting electric leakage, the method being applied to the device (10) for detecting electric leakage according to any one of claims 1 to 13, comprising:

when the power supply (20) is positively discharged through the first phase discharge path, the first detection circuit (111) being conducted to control the sampling unit (12) to collect (S101) the first detected voltage from the first detection circuit (111);
when the power supply (20) is positively discharged through the second phase discharge path, the second detection circuit (112) being conducted to control the sampling unit (12) to collect (S102) the second detected voltage from the second detection circuit (112); and
comparing the voltage difference between the first detected voltage and the second detected voltage with a threshold voltage, and determining (S103) that a electric-leakage fault occurs in the power supply when the voltage difference is greater than the threshold voltage.

15. A vehicle, comprising a power supply (20) and a device (10) for detecting electric leakage according to any one of claims 1 to 13, the power supply (20) configured to be connected to a first phase discharge path and a second phase discharge path, to discharge through the first phase discharge path and the second phase discharge path, and to output an alternating current, and the device (10) comprising a detection assembly and a sampling assembly, and configured to detect electric leakage on the first phase discharge path and the second phase discharge path when the power supply (20) is discharged.

100

Device for detecting
electric leakage — 10

Power supply — 20

FIG. 1

10

Detection unit — 11

Sampling unit — 12

Signal processing unit — 13

FIG. 2

FIG. 3

FIG. 4

FIG. 5

FIG. 6

FIG. 7

FIG. 8

When the power supply is positively discharged through the first phase discharge path, conducting the first detection circuit, to control the sampling unit to collect the first detected voltage from the first detection circuit — S101

When the power supply is positively discharged through the second phase discharge path, conducting the second detection circuit, to control the sampling unit to collect the second detected voltage from the second detection circuit — S102

Compare the voltage difference between the first detected voltage and the second detected voltage with the threshold voltage, and when the voltage difference is greater than the threshold voltage, determine that an electric-leakage fault occurs in the power supply — S103

FIG. 9

## INTERNATIONAL SEARCH REPORT

| International application No. |
| --- |
| **PCT/CN2023/104817** |

**A.  CLASSIFICATION OF SUBJECT MATTER**

G01R31/52(2020.01)i

According to International Patent Classification (IPC) or to both national classification and IPC

**B.  FIELDS SEARCHED**

Minimum documentation searched (classification system followed by classification symbols)

IPC：G01R

Documentation searched other than minimum documentation to the extent that such documents are included in the fields searched

Electronic data base consulted during the international search (name of data base and, where practicable, search terms used)

CNABS; CNTXT; CNKI; VEN; EPTXT; USTXT; WOTXT: 比亚迪股份有限公司, 陈明文, 薛鹏辉, 李维诚, 李想想, 石雷, 电位, 电压, 电源, 分压, 共模电压, 漏电, 相线, 检测, 差, 运放, 运算放大, leakage, voltage, differen+, resist+

**C.  DOCUMENTS CONSIDERED TO BE RELEVANT**

| Category* | Citation of document, with indication, where appropriate, of the relevant passages | Relevant to claim No. |
| --- | --- | --- |
| X | CN 104714183 A (FORD GLOBAL TECHNOLOGIES, L.L.C.) 17 June 2015 (2015-06-17) description, paragraphs [0050]-[0081], and figure 1 | 1-15 |
| A | CN 112462272 A (SHENZHEN YUJIAOCHENG TECHNOLOGY CO., LTD.) 09 March 2021 (2021-03-09) entire document | 1-15 |
| A | CN 107209217 A (TANASHIN DENKI CO.) 26 September 2017 (2017-09-26) entire document | 1-15 |
| A | CN 103107518 A (SHENZHEN INNOVPOWER TECHNOLOGY CO., LTD.) 15 May 2013 (2013-05-15) entire document | 1-15 |
| A | CN 216816907 U (CHONGQING ELECTRO SCIENCE AND TECHNOLOGY (GROUP) CO., LTD.) 24 June 2022 (2022-06-24) entire document | 1-15 |
| A | CN 108072846 A (HENAN BEIRUI ELECTRONIC TECHNOLOGY CO., LTD.) 25 May 2018 (2018-05-25) entire document | 1-15 |

☑ Further documents are listed in the continuation of Box C.    ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **25 August 2023** | **10 September 2023** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2023/104817**

**C.    DOCUMENTS CONSIDERED TO BE RELEVANT**

| Category* | Citation of document, with indication, where appropriate, of the relevant passages | Relevant to claim No. |
|---|---|---|
| A | JP 2001352663 A (HIKARI SHOKO K. K.) 21 December 2001 (2001-12-21)<br>entire document | 1-15 |
| A | JP 2002298725 A (YAZAKI CORP.) 11 October 2002 (2002-10-11)<br>entire document | 1-15 |

Form PCT/ISA/210 (second sheet) (July 2022)

# EP 4 549 977 A1

| INTERNATIONAL SEARCH REPORT Information on patent family members | | | | International application No. PCT/CN2023/104817 | | | |
|---|---|---|---|---|---|---|---|

| Patent document cited in search report | | | Publication date (day/month/year) | Patent family member(s) | | | Publication date (day/month/year) |
|---|---|---|---|---|---|---|---|
| CN | 104714183 | A | 17 June 2015 | US | 2015168497 | A1 | 18 June 2015 |
| | | | | US | 9194918 | B2 | 24 November 2015 |
| | | | | DE | 102014225374 | A1 | 18 June 2015 |
| | | | | DE | 102014225374 | B4 | 19 May 2022 |
| CN | 112462272 | A | 09 March 2021 | | None | | |
| CN | 107209217 | A | 26 September 2017 | TW | 201621331 | A | 16 June 2016 |
| | | | | JP | 5770903 | B1 | 26 August 2015 |
| | | | | JP | 2016065843 | A | 28 April 2016 |
| | | | | US | 2017307675 | A1 | 26 October 2017 |
| | | | | US | 10145886 | B2 | 04 December 2018 |
| | | | | EP | 3199959 | A1 | 02 August 2017 |
| | | | | EP | 3199959 | A4 | 06 June 2018 |
| | | | | WO | 2016047057 | A1 | 31 March 2016 |
| | | | | KR | 20170018459 | A | 17 February 2017 |
| | | | | KR | 101748554 | B1 | 27 June 2017 |
| | | | | CN | 107209217 | B | 30 November 2018 |
| | | | | TW | I557412 | B | 11 November 2016 |
| CN | 103107518 | A | 15 May 2013 | CN | 103107518 | B | 23 September 2015 |
| CN | 216816907 | U | 24 June 2022 | | None | | |
| CN | 108072846 | A | 25 May 2018 | | None | | |
| JP | 2001352663 | A | 21 December 2001 | JP | 3652584 | B2 | 25 May 2005 |
| JP | 2002298725 | A | 11 October 2002 | | None | | |

Form PCT/ISA/210 (patent family annex) (July 2022)

26

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210898895X